# EUROPÄISCHE PATENTANMELDUNG

(11) **EP 1 085 796 A2**
(43) Veröffentlichungstag der Anmeldung: **21.03.2001**
(21) Anmeldenummer: 00119882.9
(22) Anmeldetag: 13.09.2000
(51) Int. Cl.: H05K 7/20

(54) **Kühlsystem zur Verwendung für die Kühlung elektronischer Ausrüstungen**

(30) Priorität: 13.09.1999 GB 9921594
(71) Anmelder: BRITISH BROADCASTING CORPORATION, London W1A 1AA (GB); Trox (UK) Limited, Norfolk IP24 3SQ (GB)
(72) Erfinder: Miller, David Jonathan, Teddington Middlesex TW11 8JN (GB); Sams, Ian James, Colchester Essex 006 1JG (GB); Holland, Michael James, Watton, Thetford Norfolk, IP25 6HC (GB); Fields, Simon David, Thetford Norfolk IP24 3BW (GB)
(74) Vertreter: DR. STARK & PARTNER

(57) **Zusammenfassung**

Ein System zur Kühlung elektronischer Ausrüstungen, insbesondere in Gestellen montierter elektronischer Moduleinheiten, wobei jede ein Gehäuse mit einem Lufteinlaß, einem Luftauslaß sowie einem Lüfter zur Kühlung der Inhalte der Einheit besitzt. Das System verwendet eine Kälteeinheit, angeordnet zwischen angrenzenden Gestellen, um gekühlte Luft an die Umgebungsluft zurückzugeben, wobei es sich bei jedem davon um eine Rohranordnung handeln kann, die mit einer Tiefkühlwasserversorgung verbunden ist. Ein die Rohranordnung abdeckendes Prallblech verbessert den Wärmetausch und bietet einen gleichmäßigeren Wärmeübergang zu jeder Anordnung, so daß es möglich ist, in jedem Gestell optimale Temperaturdifferenzen zu erzielen. Eine in gleitender Weise bewegbare Rahmenkonstruktion stützt die Rohranordnung ab und definiert einen Luftraum auf der gekühlten Luftseite der Anordnung. Eine Hilfsrohranordnung verläuft auf der Rückseite der Gestelle, so daß sie mit den rückseitigen Lufträumen hinter den Gestellen kommuniziert und dadurch durch die rückseitigen Lufträume strömende erwärmte Luft gekühlt wird. Eine Hilfswärmeabzugsvorrichtung, betrieben durch einen unabhängigen Stromgenerator, umfaßt einen in einem Rücklaufrohr der Rohranordnung angeordneten Temperatursensor und einen Schalter, der auf ein Ausgangssignal des Sensors reagiert, so daß der Generator in Gang gesetzt wird, um dem Kühlmittel Wärme zu entziehen, wenn die Kühlmittelrücklauftemperatur aufgrund eines Ausfalls der die Hauptwärmeabzugsvorrichtung antreibenden Stromversorgung unter einen vorbestimmten Wert fällt.

## Beschreibung

Die vorliegende Erfindung betrifft ein Kühlsystem zur Verwendung für die Kühlung elektronischer Ausrüstungen, zu denen auch in Gestellen montierte elektronische Einheiten zählen. Derartige Einheiten besitzen typischerweise ein belüftetes Gehäuse und einen Lüfter für die Kühlung der Bauteile im Gehäuse, wenn aber mehrere Einheiten eng auf Gestellen gestapelt sind, ist die übliche Belüftung nicht wirksam, und einige Einheiten können überhitzen und dadurch ausfallen. Die vorliegende Erfindung befaßt sich mit diesem Problem.

In der Vergangenheit waren analoge elektronische Schaltkreise offener gebaut, so daß sie gekühlt werden konnten, wenn dem Aufstellungsraum, in dem sie installiert waren, Gebläseluft zugeführt wurde. Wenn derartige analoge Ausrüstungen auf Gestellen installiert waren, konnten sie daher durch Kühlluft in dem Aufstellungsraum, in dem das Gestell oder die Gestelle installiert waren, gekühlt werden. Mit dem Trend nach zunehmender Verwendung digitaler Ausrüstungen sind digitale elektronische Schaltkreise nunmehr jedoch häufig in Einheiten in Modulbauweise, von denen jede üblicherweise ein Gehäuse in Modulgröße (beispielsweise 600 mm x 500 mm) umfaßt, untergebracht und so ausgelegt, daß sie in einen entsprechenden Raum in einem Gestell passen, wobei das Gestell eine aus übereinander montierten derartigen elektronischen Einheiten bestehende Säule aufnimmt und mehrere Gestelle nebeneinander in einem Aufstellungsraum mit normaler Temperaturregelung positioniert sind. Die elektronischen Einheiten und die Gestelle sind als gefällig ausgebildete Säulen und Reihen ausgeführt, so daß die Frontplatten untereinander bündig abschließen. Obwohl dies ein schöneres Aussehen zur Folge hat, können dadurch zumindest einige der elektronischen Einheiten überhitzen, wie nachstehend ausführlicher beschrieben.

Einzelne elektronische Einheiten enthalten, allgemein gesagt, Bauteile, die Wärme erzeugen, wenn der Einheit Strom zugeführt wird. Derartige elektronische Einheiten sind jedoch so ausgeführt, daß sie gekühlt und durch "an Bord" befindliche Luftkühlmittel, die über einen Einlaß und einen Auslaß im Gehäuse sowie über einen internen Lüfter verfügen, der einen vom Einlaß zum Auslaß verlaufenden Strom kühler Umgebungsluft, der über die Bauteile strömt, herbeiführt, auf einer sicheren Betriebstemperatur gehalten werden. Während solche Luftkühlmittel für einzelne elektronische Einheiten, wenn diese an der freien Luft angeordnet sind, zufriedenstellend arbeiten, kann das Problem einer Überhitzung dann auftreten, wenn die elektronischen Einheiten auf direkt angrenzenden Gestellen eng gestapelt sind. Diese Überhitzung kann auch dann auftreten, wenn Spalte zwischen angrenzenden Gestellen vorhanden sind und ein rückseitiger Luftraum hinter den Gestellen vorgesehen ist. Der rückseitige Luftraum ist normalerweise viel größer als der Zwischenraum zwischen den Gestellen, weil in ihm Kabel untergebracht sind, aber diese Lufträume stellen keine verläßliche Kühlmethode für auf Gestellen montierte elektronische (insbesondere digitale) Einheiten dar, weil keine ausreichende Luftströmung stattfinden kann.

Das letztgenannte Problem wird durch die zunehmende Anzahl von nebeneinander im selben Aufstellungsraum positionierter Gestelle und durch die (aus Platzersparnisgründen) reduzierte Breite der zwischen Gestellen vorhandenen Luftspalte noch erschwert. Während beispielsweise eine Säule aus in einem ersten Gestell montierter elektronischer Einheiten der einströmenden "kalten" Umgebungsluft am nächsten liegt und ausreichend gekühlt werden kann, kann die Temperatur der Luft, die beim Durchströmen durch jede dieser Einheiten erwärmt wird, um etwa 5°C bis 10°C ansteigen. Während diese erwärmte Luft aus den Luftauslässen der elektronischen Einheiten im ersten Gestell in den Spalt zwischen den Gestellen entweichen kann, wenn die Lufteinlässe der elektronischen Einheiten im zweiten angrenzenden Gestell in der gleichen Modulhöhe wie die Luftauslässe der elektronischen Einheiten im ersten Gestell positioniert sind, können die Lüfter in den Einheiten des zweiten Gestells diese erwärmte Luft (statt kälterer Umgebungsluft aus den seitlichen oder rückseitigen Lufträumen) herbeiführen, die dann in die nachgeschalteten Einheiten strömt und eine Erhöhung der Lufttemperatur bewirkt. Dies geschieht bei elektronischen Einheiten, die in den gleichen Modulhöhen positioniert sind, in jedem Paar angrenzender Gestelle, wodurch die Lufttemperatur von einem Ende der Gestelle zum nächsten progressiv und kumulativ ansteigt. So kann beispielsweise der Anstieg der Temperatur von Gestell zu Gestell ausreichen, um letztendlich eine Luftaustrittstemperatur von mehr als etwa 50°C zu erzeugen. Da die elektronischen Einheiten nicht für einen Betrieb bei einer derartigen Temperatur ausgelegt sind, wird die Lebensdauer überhitzter elektronischer Einheiten beträchtlich verringert, in manchen Fällen beispielsweise auf nur wenige Wochen. Eine derartige Überhitzung kann selbstverständlich nicht toleriert werden, und zwar nicht nur wegen der hohen Kosten, die mit dem Ersatz teurer elektronischer Einheiten verbunden sind, sondern auch aufgrund der mit Abschaltzeiten, Unannehmlichkeiten und Wiederinstandsetzungen verbundenen Probleme.

Dieses Problem läßt sich nicht durch Steigerung des Luftdurchsatzes der internen Lüfter lösen, da die erwärmte Luft aus einem Auslaß einer vorgeschalteten elektronischen Einheit immer noch dem Lufteinlaß der angrenzenden nachgeschalteten elektronischen Einheit zugeführt wird und die Luftspalte zwischen den angrenzenden Gestellen (und dem rückseitigen Luftraum) es nicht zulassen würden, daß genügend kalte Umgebungsluft in die Lufteinlässe nachgeschalteter elektronischer Einheiten hineingezogen wird, um eine Überhitzung von einigen dieser Einheiten zu verhindern (aufgrund des kumulativen Temperaturanstiegs).

Versuche, die unternommen wurden, um dieses Problem durch Kühlung der Luft in dem Aufstellungsraum, in dem die elektronischen Einheiten installiert sind, zu bewältigen, sind nicht gänzlich erfolgreich gewesen. Eine wirksamere Kühlung kann erreicht werden, wenn kalte Luft durch unter Bodenniveau vorgesehene Kanäle geleitet wird und diese Kanäle zu hinter den elektronischen Einheiten in den Gestellen vorhandenen rückseitigen Lufträumen geführt werden. Ein Gestell aus, sagen wir, zehn elektronischen Einheiten kann etwa 1 Kilowatt Wärme erzeugen, so daß durch die in 10 angrenzenden Gestellen vorhandenen elektronischen Einheiten 10 Kilowatt Wärme erzeugt werden würde. Aufgrund räumlicher Begrenzungen verbleiben lediglich enge Spalte zwischen angrenzenden Gestellen und dadurch entsteht zuviel Strömungsimpedanz, um eine wirksame Kühlung durch Gebläsetiefkühlluft erreichen zu können. Der rückseitige Luftraum ist oft vergleichsweise groß, allerdings durch große Mengen Kabel versperrt, und gerade auf der Rückseite der elektronischen Einheiten und nicht an den Seiten besteht eine große Nähe zwischen vorgeschalteten Luftauslässen, die nachgeschalteten Lufteinlässen gegenüberliegen, wenn elektronische Einheiten in Modulausführung in entsprechenden Höhen gestapelt sind. Während daher eine Überhitzung durch Zuführung kalter Luft über Bodenhohlräume verringert werden kann, hat sich dies als eine unzuverlässige Methode erwiesen. Außerdem ist übermäßiges Abkühlen der Umgebungsluft ineffizient.

Ein Problem, mit dem sich die vorliegende Erfindung auseinandersetzt, betrifft nicht nur die Kühlung einzelner elektronischer Einheiten in erforderlichem Umfang, sondern außerdem die Sicherstellung einer gleichmäßigen Kühlung vieler elektronischer Einheiten in mehreren angrenzenden Gestellen. So können beispielsweise elektronische Einheiten, die für einen Betrieb bei Raumtemperatur ausgelegt sind, in idealer Weise auf einer allgemein gleichmäßigen Umgebungstemperatur innerhalb des Bereichs von 20°C bis 24°C gehalten werden. Während es vergleichsweise einfach sein mag, Gestelle vorgeschalteter elektronischer Einheiten auf einer solchen Temperatur zu halten, da die einströmende kühle Luft zuerst zu ihnen gelangt, besteht immer noch das Problem, eine ausreichende Kühlung von Gestell zu Gestell aufrechtzuerhalten, weil nachgeschaltete elektronische Einheiten eher zu Überhitzungen neigen. Darüber hinaus ist es erforderlich, eine Überkühlung vorgeschalteter elektronischer Einheiten zu verhindern, weil dies zu Kondensationsproblemen führen könnte.

Das Problem, mit dem sich die vorliegende Erfindung auseinandersetzt, besteht darin, für die Kühlung von in Gestellen montierten elektronischen Einheiten eine preiswerte, aber dennoch wirksame Methode bereitzustellen, die darauf abzielt, eine vorbestimmte und im wesentlichen gleichmäßige Betriebstemperatur für die elektronischen Einheiten in angrenzenden Gestellen zur Verfügung zu stellen.

Die vorliegende Erfindung löst dieses Problem dadurch, daß sie ein Kühlsystem für in Gestellen montierte elektronische Einheiten bereitstellt, wobei jede dieser Einheiten ein Gehäuse mit einem Lufteinlaß, einem Luftauslaß sowie einer Vorrichtung für die Herbeiführung eines Umgebungsluftstroms vom Einlaß zum Auslaß umfaßt, um den Inhalt der elektronischen Einheit zu kühlen;
wobei das Kühlsystem mindestens eine zwischen angrenzenden vorgeschalteten und nachgeschalteten Gestellen angeordnete Kälteeinheit umfaßt, wobei die Kälteeinheit Mittel für den Anschluß an eine Wärmeabzugsvorrichtung besitzt, so daß, wenn die Kälteeinheit Luft erhält, die beim Durchgang durch eine oder mehrere Einheiten in einem vorgeschalteten Gestell erwärmt wurde, die Kälteeinheit der Luft, bevor sie erneut der Umgebungsluft zugeführt wird, Wärme entzieht.

Die Kälteeinheit kann jede beliebige Bauart aufweisen, die in der Lage ist, die Wärme aus einem erwärmten Luftstrom abzuziehen und dadurch Wärme von der in Gestellen montierten elektronischen Ausrüstung zu entfernen. Vorrichtungen, mit denen dies erreicht werden kann, werden normalerweise als "Kühlkörper" bezeichnet. Sie können ein Kühlmittel enthaltendes Reservoir besitzen, wobei das Reservoir Wände mit einer großen Oberfläche aufweist, um einen Wärmeübergang zu unterstützen. Diese Oberfläche kann durch Rippen oder gleichwertige Oberflächenausbildungen, die entweder an den Reservoirwänden angebracht oder Bestandteile dieser Wände sind, vergrößert werden. Diese Vorrichtungen können auch einige Mittel beinhalten, die bewirken, daß erwärmte Luft über den größten Teil der Wärmetauscherfläche oder über die gesamte Wärmetauscherfläche strömt und/oder ein turbulenter Strom erzeugt wird. Obwohl die einfachsten Vorrichtungen, bei denen ein Flüssigkühlmittelstrom zum Einsatz kommt, bevorzugt werden, ist dies kein entscheidender Punkt, denn es könnten auch Kälteeinheiten eingesetzt werden, bei denen "Verdampfung", "Zustandsveränderung", "Expansion" oder irgendein "elektronischer Effekt" zur Anwendung kommt, um dieses Ziel zu erreichen.

Bei der Kälteeinheit handelt es sich vorzugsweise um eine Rohranordnung, die beliebig ausgeführt sein kann, jedoch vorzugsweise ein wärmeleitfähiges Rohr oder wärmeleitfähige Rohre (beispielsweise aus Kupfer) umfaßt, die Kühlmittel (beispielsweise Wasser) über einen kontinuierlichen Serpentinenweg leiten, der im Betrieb in dem zwischen angrenzenden Gestellen vorhandenen Raum angeordnet ist. Das Rohr oder die Rohre weisen vorzugsweise Rippen auf, um den Wärmetausch zwischen der erwärmten Luft und dem Kühlmittel zu steigern. Derartige Rippen bestehen aus einem guten Wärmeleiter, beispielsweise Aluminium, und verlaufen wie parallele Platten quer über die Rohre. Bei dem Kühlmittel handelt es sich vorzugsweise um Tiefkühlwasser (es können aber auch andere Kühlmittel verwendet werden), das der Rohranordnung durch mit einem Wärmetauscher in einem Kälteerzeugungssystem verbundene Rohre problemlos zugeführt werden kann. Dieses Kälteerzeugungssystem kann Bestandteil der Anlage sein, die beispielsweise in einem großen Gebäude zur Raumklimatisierung verwendet und über die Netzstromversorgung betrieben wird, um den Klimatisierungseinheiten zugeführtes Kühlmittel tiefzukühlen. Ein derartiges Kälteerzeugungssystem läßt sich einfach an einen zusätzlichen Wärmetauscher anschließen, der dann das im erfindungsgemäßen Kühlsystem verwendete Kühlmittel von im Kälteerzeugungssystem zirkulierendem Kühlmittel abtrennt. Wasser wird wegen seiner hohen Wärmeleistung und weil es sehr leicht und zu sehr geringen Kosten auf, sagen wir, etwa 13°C oder 14°C abgekühlt werden kann, bevorzugt als Kühlmittel eingesetzt. Indem dafür gesorgt wird, daß das Tiefkühlwasser durch die Rohranordnung strömt (die eine Schlange in einer Reihe ähnlicher Schlangen bildet, die parallel über einen Kühlmitteleinlaß und -auslaß verbunden sind), kann der warmen Luft, die aus den Kühllüftern an jeder der vorgeschalteten Einheiten austritt, genügend Wärme entzogen werden.

Während diese zwischen Gestellen vorgesehene Rohranordnung so ausgeführt sein kann, daß eine erforderliche und vorbestimmte Kühlmenge bereitgestellt wird, wenn die seitlichen Luftauslässe aus den elektronischen Einheiten in einem vorgeschalteten Gestell bewirken, daß erwärmte Luft durch Zonen der Rohre, die den seitlichen Lufteinlässen der elektronischen Einheiten im angrenzenden nachgeschalteten Gestell direkt gegenüberliegen, geleitet wird, kann es sein, daß ein Teil der Rohranordnung dann nicht viel (wenn überhaupt etwas) von dieser erwärmten Luft erhält.

Um diesen lokalisierten Effekt zu vermeiden, wird vorzugsweise ein Prallblech vorgesehen, um den erwärmten Luftstrom, der aus den Luftauslässen der elektronischen Einheiten im vorgeschalteten Gestell austritt, umzulenken, wodurch die erwärmte Luft gleichmäßiger und turbulenter auf die Rohre in der Anordnung verteilt wird. Ein beispielsweise hinter der Rohranordnung (d.h. nachgeschaltet) vorgesehenes Prallblech verhindert, daß der erwärmte Luftstrom, der aus den seitlichen Luftauslässen der vorgeschalteten elektronischen Einheiten austritt, direkt durch die Rohranordnung in die seitlichen Einlässe der nachgeschalteten elektronischen Einheiten gelangt, so daß dieser erwärmte Luftstrom dann über die zu kühlende Rohranordnung umgelenkt wird und gekühlte Luft dann zu einer Seite oder vorzugsweise zu beiden Seiten der Anordnung strömt, wo sie in den Aufstellungsraum und/oder in einen rückseitigen Luftraum hinter den elektronischen Einheiten im Gestell austritt.

In einer bevorzugten Ausführungsform handelt es sich bei dem Prallblech um ein Blech, das (bezogen auf die Richtung des erwärmten Luftstroms) nach der Rohranordnung vorgesehen ist, und das Prallblech ist von einem oder mehreren Lochelementen flankiert, die es ermöglichen, daß über die Rohranordnung geströmte Luft vorne oder hinten an den Gestellen austreten kann. Der Spalt zwischen angrenzenden Gestellen ist breit genug, um die Rohranordnung und das Prallblech aufnehmen zu können, während außerdem seitliche Lufträume (a) zwischen den Seiten der elektronischen Einheiten im vorgeschalteten Gestell und der Rohranordnung sowie (b) zwischen dem Prallblech und den Seiten der elektronischen Einheiten im angrenzenden nachgeschalteten Gestell vorgesehen sind. Obwohl ein derartiges Prallblech eine einfache Konstruktion darstellt, werden damit überraschend gute Resultate erzielt. So kann beispielsweise ein Prallblech, das den größten Teil der Fläche der Rohranordnung (oder im wesentlichen die gesamte Fläche der Rohranordnung) abdeckt, (wobei diese Fläche in der vertikalen Ebene in dem Raum zwischen angrenzenden Gestellen gemessen wird), eine Druckdifferenz am Prallblech erzeugen, so daß der Luftdruck im Luftraum auf der nachgeschalteten Seite des Prallblechs geringer als derjenige auf der vorgeschalteten Seite des Prallblechs ist. Somit wird die erwärmte Luft, die durch den von der Rohranordnung eingenommenen seitlichen Luftraum gedrückt wird, wirksamer gekühlt, weil ein größerer Wärmetausch mit dem Kühlmittel erfolgt, und gekühlte Luft tritt dann an der Vorder- und Rückseite aus, während kalte Umgebungsluft auf der dem Prallblech nachgeschalteten anderen Seite in den Luftraum und damit in die Einlässe der Einheiten in den nachgeschalteten Gestellen eintritt. Der Einsatz dieser Prallbleche bei in Gestellen montierten elektronischen Einheiten, die mit seitlichen Lufteinlässen und -auslässen ausgestattet sind, kann äußerst wirksam sein, um die Temperatur des erwärmten Luftstroms zu reduzieren und einen im wesentlichen gleichmäßigen Temperaturabfall in den elektronischen Einheiten in angrenzenden Gestellen aufrechtzuerhalten.

Durch geeignete Auslegung der Rohranordnungen und des Prallblechs sowie durch Strömungsregelung des Tieftemperaturkühlmittels hat es sich, um nur ein Beispiel zu nennen, als möglich erwiesen, einen stabilen Zustand mit einer Temperaturdifferenz von lediglich etwa 3°C - 5°C in jedem der mehreren Gestelle (d.h. ohne jeglichen kumulativen Effekt) zu erzielen. Der Strom des als Kühlmittel eingesetzten Wassers war so beschaffen, daß die Eingangstemperatur (Rücklauf) des als Kühlmittel verwendeten Wassers 14°C und die Ausgangstemperatur (Zulauf) des als Kühlmittel verwendeten Wassers 17°C betrug. In diesem Beispiel waren zwischen Gestellen vorgesehene Rohranordnungen (Schlangen) in den Räumen zwischen drei angrenzenden Gestellen, die jeweils zehn Einheiten enthielten, installiert. Die Schlangen waren parallel zum Kühlmittelzulauf und -rücklauf angeschlossen, die Bestandteile einer Kühlmittelschleife mit einem Wärmetauscher waren, der über ausreichende Kapazität verfügte, um eine Rücklaufkühlmitteltemperatur von 17°C aufrechtzuerhalten. Neben der Tatsache, daß sich das System preiswert installieren, betreiben und warten läßt, zeigt dieses Ergebnis eine wesentliche Verbesserung. Es löst daher das Problem kumulativer Temperaturen, weil die Eingangsluft zu jeder Einheit effektiv die gleiche Tieftemperatur aufweist.

Obwohl spezifische Ausführungsformen der vorliegenden Erfindung sich hauptsächlich mit dem Problem der Überhitzung auseinandersetzen, die auf die Montage elektronischer Moduleinheiten in Gestellen zurückzuführen ist, wo erwärmte Luft aus dem Auslaß einer vorgeschalteten Einheit in den Lufteinlaß einer nachgeschalteten Einheit gelangen kann, läßt sich die vorliegende Erfindung auch für weitere Anwendungen einsetzen. In dem Fall, in dem elektronische Einheiten in angrenzenden Gestellen über Lüfter und Entlüftungen verfügen, die einen Luftstrom in gleicher Richtung von Gestell zu Gestell herbeiführen, können die elektronischen Moduleinheiten generell in gleicher Weise ausgeführt sein. Wenn jedoch eine elektronische Einheit auf dem Gestell montiert ist, können ihr interner Lüfter und ihre Entlüftung Luft in entgegengesetzter Richtung zu derjenigen Luft leiten, die durch eine ähnliche Einheit auf einem angrenzenden Gestell in der gleichen Modulhöhe strömt. In diesem Fall strömt die erwärmte Luft, die aus angrenzenden Einheiten austritt, (in entgegengesetzten Richtungen) in den Zwischenraum zwischen den angrenzenden Gestellen. Um dieses Problem zu lösen, kann in dem Zwischenraum eine Kälteeinheit montiert werden, die so ausgelegt und ausgeführt ist, daß sie einen ausreichenden Kühlkörper für die von den angrenzenden, auf Gestellen montierten Einheiten erzeugte Wärme bereitstellt, wodurch gekühlte Luft (an der Vorder- und Rückseite) mit einer Temperatur, die der Umgebungsluft ähnlich ist oder dieser nahekommt, an die Umgebungsluft zurückgegeben wird. Bei einer derartigen Installation mag ein Prallblech nicht erforderlich sein, weil entgegengesetzte direkte Luftströme zusammentreffen und eine ausgeprägtere Turbulenz bewirken und damit den Wärmeübergang zur dazwischen angeordneten Kälteeinheit unterstützen. Es kann beispielsweise eine mit Rippen ausgestattete Rohranordnung ohne Prallbleche zwischen solchen angrenzenden Gestellen vorgesehen werden. Eine Installation dieser Ausführung verfügt über Gestellzwischenräume, die abwechselnd eine Kälteeinheit enthalten und einen Luftraum definieren.

In dem Fall, in dem elektronische Einheiten in einem Gestell montiert sind, wo Luft von der Vorder- zur Rückseite strömt, wäre es auch möglich, die Kälteeinheit so zu montieren, daß sie die Rückwand des rückseitigen Luftraums hinter den Einheiten im Gestell bildet. In diesem Fall strömt in die vorderen Lufteinlässe gelangende Umgebungsluft durch die elektronischen Einheiten und tritt in den rückseitigen Luftraum ein, bevor sie durch die Kälteeinheit in den umgebenden Aufstellungsraum gelangt.

Um bessere Zugangs- und/oder Ausführungsmöglichkeiten zu bieten, können die Gestelle mit entfernbaren Platten ausgestattet sein, die sich in einigen Fällen durch Kälteeinheiten mit ähnlichen Abmessungen ersetzen lassen.

Statt einer Installation mit Moduleinheiten, die alle die gleiche Ausführung aufweisen, beispielsweise mit seitlichen Lufteinlässen und -auslässen sowie mit Lüftern, die Luft in die gleiche Richtung leiten, müssen einige Installationen elektronischen Ausrüstungen gerecht werden, die, sagen wir, von verschiedenen Unternehmen hergestellt wurden und daher Einheiten umfassen können, bei denen der Luftstrom von links nach rechts, von rechts nach links oder von vorne nach hinten (d.h. wenn die Einheit mit sichtbarer Frontplatte auf dem Gestell montiert ist) verläuft. Diese Installation umfaßt eine Mischung derartiger Einheiten, die vorteilhaft in Gruppen angeordnet werden könnten, um, je nach Bedarf, die Verwendung dazwischen vorgesehener oder rückseitig montierter Kälteeinheiten zu ermöglichen. Sie kann jedoch auch elektronische Einheiten umfassen, die nicht (immer) in solchen ähnlichen Gruppen angeordnet werden können. Dieses Problem kann durch Modifizierung von Abschnitten der Kälteeinheit gelöst werden. So können beispielsweise die auf Gestellen montierten unteren drei Einheiten eine dazwischen vorgesehene Kälteeinheit und ein Prallblech für die in gleicher Richtung strömende erwärmte Luft erfordern. Bei den nächsten (oberen) drei Einheiten kann die Luft in entgegengesetzten Richtungen strömen, so daß die Kälteeinheit kein Prallblech benötigt. Bei den oberen vier Einheiten kann die Luft von vorne nach hinten strömen, so daß der Gestellzwischenraum einfach leer ist. Die vorliegende Erfindung kann somit angewendet werden, wenn die Auslegung Änderungen in verschiedenen Ebenen der Gestelle beinhaltet. Dadurch kann den Auswirkungen, die sich aus unterschiedlichen Auslegungen elektronischer Ausrüstungen ergeben, entgegengewirkt werden, aber in den meisten Fällen lassen sich elektronische Ausrüstungen standardisieren, so daß Hybridauslegungen vermieden werden können.

Ein Kühlsystem nach vorliegender Erfindung ist nicht nur hinsichtlich seines Kühleffekts wirksam, es läßt sich auch einfach installieren. So kann beispielsweise eine Rahmenkonstruktion für die Abstützung der bevorzugten Rohranordnung bereitgestellt werden, wobei die Rahmenkonstruktion so dimensioniert ist, daß sie zwischen angrenzenden Gestellen eingefügt werden kann. Obwohl sich diese auch als Festkonstruktion ausführen läßt, wird es bevorzugt, die Rohranordnung auf einer Rahmenkonstruktion zu montieren, die sich leicht aus dem Raum zwischen angrenzenden Gestellen entfernen läßt, um Installation und Wartung zu erleichtern. So können beispielsweise die Rahmenkonstruktion und der Bodenraum, auf dem die Rahmenkonstruktion gleitet, reibungsreduzierende Mittel, wie beispielsweise auf einer Schiene montierte Rollen oder Gleit- oder andere Vorrichtungen, umfassen, um das Hineinschieben und Herausziehen der Rahmenkonstruktion zu erleichtern. In einer bevorzugten Ausführungsform sind angrenzende Gestelle untereinander durch Konstruktionselemente gesichert, die einen Schlitz definieren, von dem die (die Rohranordnung tragende) Rahmenkonstruktion aufgenommen wird.

Die Rohranordnung ist vorzugsweise so angeordnet, daß ein Luftraum zwischen dem Prallblech und den gegenüberliegenden Seiten der in einem angrenzenden Gestell montierten Einheiten zur Verfügung steht. Dieser Luftraum besitzt beispielsweise einen im wesentlichen rechtwinkligen Querschnitt, er verläuft von der unteren zur oberen Einheit im Gestell aus nach oben und weist eine Breite auf, die eine Kammer definiert, in der der Luftdruck auf der nachgeschalteten Seite des Prallblechs geringfügig niedriger als derjenige auf der vorgeschalteten Seite des Prallblechs ist. Diese Kammer stellt Raum für die Zuführung kalter Luft in die Lufteinlässe von Einheiten im angrenzenden Gestell zur Verfügung.

Während die elektronischen Einheiten seitliche Lufteinlässe und -auslässe besitzen können, wodurch Kühlluft quer über den Inhalt der elektronischen Einheiten strömt, um eine Kühlung zu bewirken, können andere elektronische Einheiten in den Gestellen montiert sein, die über vordere und rückseitige Lufteinlässe und -auslässe sowie über einen Lüfter verfügen, um den von vorne nach hinten verlaufenden Luftstrom herbeizuführen. Wenn elektronische Einheiten in der letztgenannten Ausführung (oder eine Mischung elektronischer Einheiten mit seitlichen Lufteinlässen/-auslässen sowie Lufteinlässen/-auslässen von vorne nach hinten) verwendet werden, wird auch ein rückseitiger Luftraum auf der Rückseite der Gestelle vorgesehen. Dieser rückseitige Luftraum wird normalerweise an der Rückseite der elektronischen Einheiten vorgesehen, um Kabel unterzubringen. Da es sich dabei, verglichen mit dem engen Luftspalt zwischen angrenzenden Gestellen, um einen großen Luftraum handelt, ist dann eine zusätzliche Kühlung erforderlich, um eine optimale gleichmäßige Temperatur in der gesamten Installation aufrechtzuerhalten.

Um das letztgenannte Problem zu bewältigen, wird eine Hilfsrohranordnung bereitgestellt, die auf der Rückseite der Gestelle verläuft, so daß eine Kommunikation mit diesen rückseitigen Lufträumen (hinter den Gestellen) erfolgt und dadurch erwärmte Luft, die durch diese Räume strömt, gekühlt wird. Diese Hilfsrohranordnung kann ein Bestandteil der Rohranordnung sein, die zwischen angrenzenden Gestellen angeordnet ist, oder sie kann, abhängig von spezifischen Erfordernissen, zusätzlich vorgesehen werden. Wenn eine derartige Hilfsrohranordnung eingesetzt wird, werden zusätzliche Mittel für die Herbeiführung eines Luftstroms (beispielsweise Lüfter) verwendet, um eine weitere Kühlung zu unterstützen. So können beispielsweise Lüfter verwendet werden, die auf Konsolen auf der vorgeschalteten (oder nachgeschalteten) Seite der Hilfsrohranordnung montiert sind. Die Hilfsrohranordnung kann auch auf derselben Rahmenkonstruktion, die auch die Hauptrohranordnung abstützt, montiert sein, damit sich beide Rohranordnungen leichter entfernen und zwischen angrenzenden Gestellen einfügen lassen und die Hilfsrohranordnung beim Einbau der Rahmenkonstruktion in den rückseitigen Luftraum hineingeschoben werden kann.

Die Rahmenkonstruktion, die der Abstützung der Rohre dient, kann vorne einen Streifen mit Öffnungen besitzen, die sich zur Umgebungsluft hin öffnen, so daß gekühlte Luft entweichen und kalte Raumluft zwischen angrenzenden Gestellen eintreten kann.

Die Hauptrohranordnung (und/oder die Hilfsrohranordnung) kann ein oder mehrere Rohre umfassen, die in paralleler Anordnung zwischen einem Kühlmitteleinlaß und einem Kühlmittelauslaß vorgesehen sind. Die Anordnung kann beispielsweise parallele Rohrabschnitte beinhalten, die vertikal nach unten und dann nach oben und anschließend wieder nach unten usw. verlaufen, wobei die oberen und unteren Enden durch rohrförmige Elemente miteinander verbunden sind, so daß flüssiges Kühlmittel in einem Serpentinenweg entlang der Rohranordnung strömt. Die Rohre können, anstatt vertikal angeordnet zu sein, auch horizontal verlaufen, obwohl dies die Verwendung einer größeren Anzahl von Bögen erfordern würde und damit weniger wirtschaftlich wäre.

Die Rohranordnung umfaßt oben und unten vorgesehene Ventile, wobei die unteren Ventile benutzt werden, um die Rohranordnung mit Kühlmittel zu befüllen, während das obere Ventil geöffnet ist, um als Entlüftung zu wirken. Das untere Ventil dient auch dazu, die Rohranordnung bei Bedarf zu entleeren. Die Rohranordnung wird, nachdem sie in dem Raum zwischen angrenzenden Gestellen installiert wurde, vorzugsweise von unten nach oben befüllt.

Im Falle elektronischer Moduleinheiten, wenn jede davon eine ähnliche vorbestimmte Größe aufweist, kann beispielsweise die zwischen Gestellen einzufügende Rohranordnung (und die im rückseitigen Luftraum anzuordnende Hilfsrohranordnung) als ein Modul zur Verwendung in einem Modulsystem ausgelegt sein, so daß eine oder mehrere Rohranordnungen mit einer bestimmten Anzahl von Rohren einer gegebenen Größe in die Anordnung eingefügt werden können, um vorbestimmte Vorlauf- und Rücklaufkühlmitteltemperaturen zu erzeugen, die der Anzahl elektronischer Einheiten, die in angrenzenden Gestellen montiert sind, sowie der Anzahl elektronischer Einheiten in jedem Gestell entsprechen. Dadurch wird es möglich, das Problem einer Überhitzung von Moduleinheiten in Gestellen schnell und einfach, und auch rückwirkend, zu lösen. Die vorliegende Erfindung läßt sich jedoch weitergehend anwenden, wenn elektronische Einheiten eng zueinander gestapelt sind.

In einer Installation, die das vorgenannte Kühlsystem beinhaltet, kann eine Wärmeabzugsvorrichtung mit den Rohranordnungen für die Kühlmittelversorgung verbunden sein. Bei der Wärmeabzugsvorrichtung kann es sich beispielsweise um einen Wärmetauscher handeln, der mit einer Wärmeabzugsvorrichtung, beispielsweise einer Klimaanlage in einem großen Gebäude, verbunden ist. Dieser Wärmetauscher trennt das als Kühlmittel verwendete Wasser im Kühlsystem gegenüber den Rohren des Klimatisierungssystems ab. Um Ausfälle in der Netzstromversorgung aufzufangen, ist eine Hilfswärmeabzugsvorrichtung vorgesehen, die durch einen unabhängigen Stromgenerator betrieben wird, und es ist ein Kühlmitteltemperatursensor vorgesehen, so daß der Generator, wenn der Sensor einen Temperaturabfall feststellt, eingeschaltet wird, um die Hilfswärmeabzugsvorrichtung zu betreiben, so daß dem Kühlmittel Wärme entzogen werden kann. Dies stellt sicher, daß eine derartige Maßnahme sofort eingeleitet wird, wenn ein vorbestimmter Anstieg der Strömungstemperatur eintritt. Dieser kann beispielsweise lediglich 1°C betragen, ist aber ausreichend, um den Betrieb des Hilfsgenerators auszulösen, so daß das Kühlsystem auch weiterhin wirksam arbeiten kann und keine übermäßige Temperatur auftritt, die ansonsten die elektronischen Einheiten in den Gestellen schädigen könnte. Die Zeitspanne, die benötigt wird, um auf den Zustand einer übermäßigen Temperatur zu reagieren, ist kürzer, wenn der Temperatursensor so positioniert ist, daß er auf die Rücklauftemperatur reagiert, insbesondere auf einen geringen Anstieg der Rücklauftemperatur in unmittelbarer Nähe eines Wärmetauschers, und somit kann jede Ursache, die diesen Zustand herbeiführt, beispielsweise ein Ausfall des Hauptgenerators, schneller festgestellt werden. Neben einem Wärmetauscher, der in den Hauptkältemittelkreislauf eingebunden ist, der die Kühlmittelrücklauftemperatur normalerweise auf einem stabilen Wert hält, kann die Hilfskälteerzeugungsvorrichtung ihren eigenen Wärmetauscher in der Kühlmittelschleife besitzen.

Eine Ausführungsform der vorliegenden Erfindung wird nunmehr unter Bezugnahme auf die beiliegenden Schemazeichnungen beschrieben, wobei:
- Fig. 1a: ein Aufriß einer Anordnung nach dem Stand der Technik ist, bei der elektronische Einheiten in angrenzenden Gestellen untergebracht sind; Fig. 1b eine Draufsicht der gleichen Anordnung nach dem Stand der Technik ist; die Figuren 1c und 1d die Bauweise der Einheiten zeigen; und Fig. 1e einen aufeinanderfolgenden Anstieg der Lufttemperatur über drei Gestelle zeigt;
- Fig. 2a: eine perspektivische Darstellung einer erfindungsgemäßen Installation ist, die eine Rahmenkonstruktion zeigt, die eine Kühlschlange oder eine Rohranordnung abstützt, die so angeordnet ist, daß sie in gleitender Weise in einen Spalt zwischen angrenzenden Gestellen hineingeschoben werden kann;
- Fig. 2b: eine Vergrößerung eines Abschnitts des Gestells von Fig. 2a zeigt, aus der die Richtung des Luftstroms ersichtlich ist;
- Fig. 2c: eine Draufsicht eines Teils des Gestells ist, die Einheiten mit einem von Seite zu Seite verlaufenden Luftstrom zeigt;
- Fig. 2d: eine Draufsicht ist, die Einheiten mit von vorne nach hinten verlaufendem Luftstrom zeigt;
- Fig. 3: ein Seitenriß ist, der die Rohranordnung detaillierter zeigt;
- Fig. 4: die Rahmenkonstruktion zeigt, auf der sich die Rohranordnung (in Abwesenheit der Rohranordnung) abstützt; und
- Fig. 5: ein Schaltschema ist, das verschiedene Rohranordnungen zeigt, die an eine Kühlmittelschleife angeschlossen sind, die wiederum mit den Haupt- und Hilfskälteerzeugungseinheiten verbunden ist;
- Fig. 6: eine Draufsicht ist, die eine andere Gestellanordnung mit entgegengesetzt verlaufenden Luftströmen zeigt;
- Fig. 7a,b: Draufsichten modifizierter Gestelle sind; und
- Fig. 8: eine perspektivische Darstellung einer modifizierten Prallblechanordnung ist.

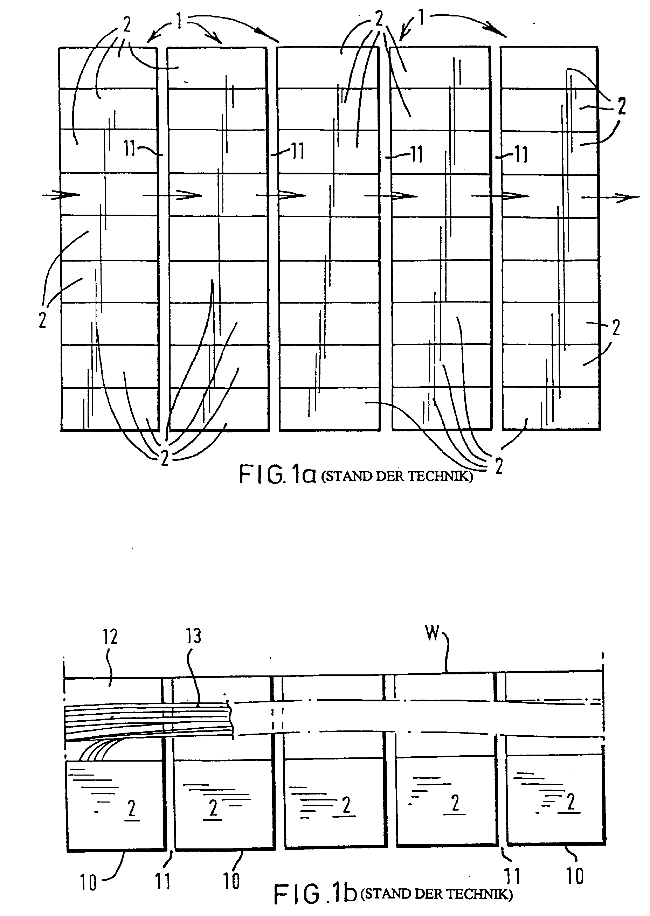

Die Figuren 1a - 1d zeigen eine herkömmliche Installation, die eine Reihe von Gestellen 1 umfaßt, von denen jedes eine Säule aus digitalen elektronischen Moduleinheiten 2 enthält, wobei die Gestelle seitlich nebeneinander mit einem dazwischenliegenden engen Luftspalt 11 montiert sind. Alle Einheiten 2 besitzen nach außen ausgerichtete Frontplatten und schließen untereinander bündig ab. Die Einheiten 2 erstrecken sich teilweise in den Gestellraum hinein, wie in Fig. 1b dargestellt, so daß ein rückseitiger Luftraum 12 (begrenzt durch die Wände W des Aufstellungsraums, in dem die Ausrüstung installiert ist) verbleibt, der normalerweise von Kabeln 13 belegt ist. Der rückseitige Raum erstreckt sich üblicherweise über die Breite der Gestelle 1.

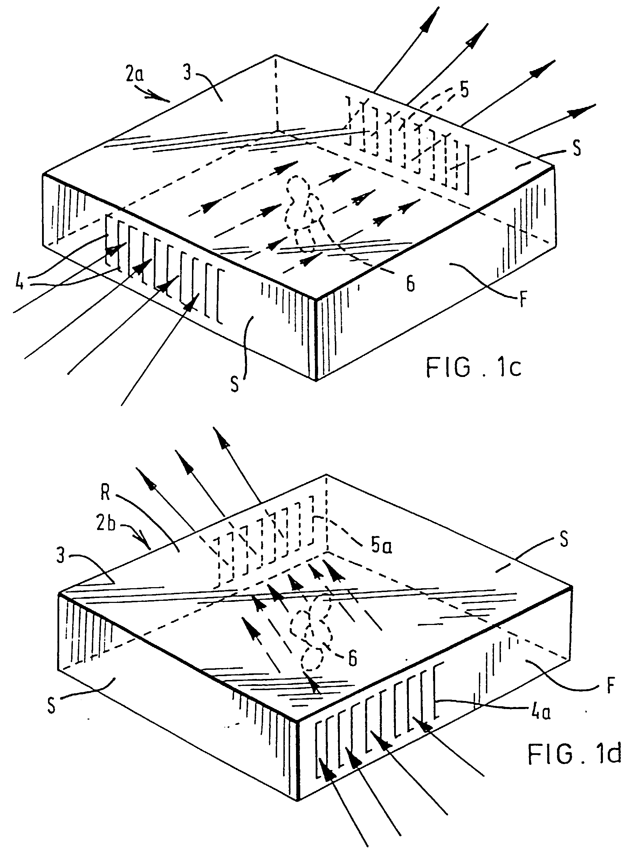

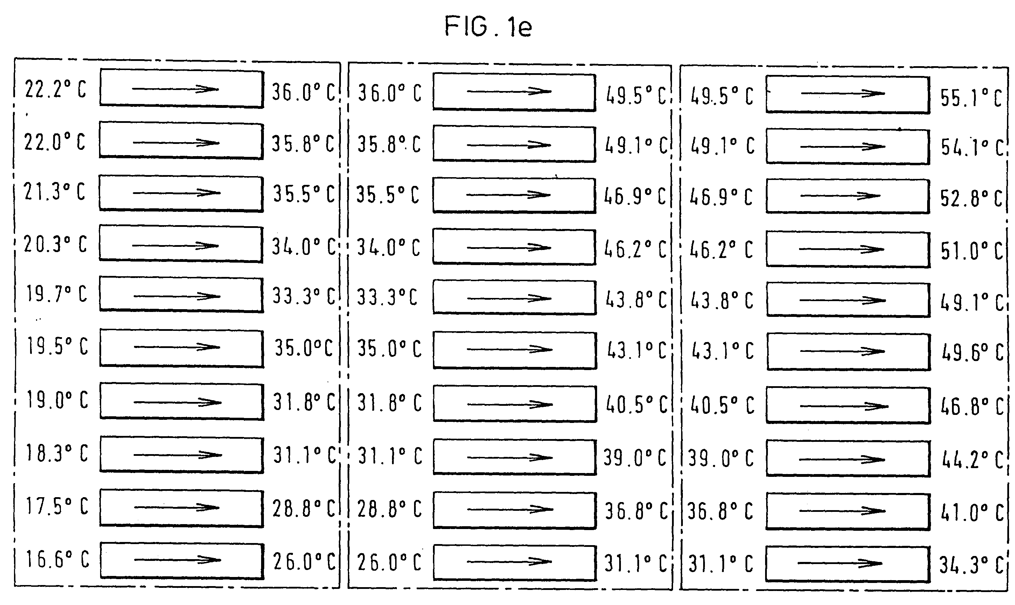

Wie in den Figuren 1c und 1d dargestellt, umfaßt jede Einheit 2 ein Gehäuse 3 mit einem Lufteinlaß 4, 4a, einem Luftauslaß 5, 5a sowie einem Lüfter 6, der aus der Umgebung Luft in das Gehäuse 3 hineinzieht, wo sie über die Schaltkreise strömt und den Bauteilen Wärme entzieht, so daß erwärmte Luft aus den Luftauslässen austritt. Die in Fig. 1c dargestellte Einheit 2a besitzt einen seitlichen Lufteinlaß 4 und einen seitlichen Luftauslaß 5 in Seitenplatten S, während die in Fig. 1d dargestellte Einheit einen vorderen Lufteinlaß 4a und einen rückseitigen Auslaß 5a in vorderen und rückseitigen Platten F und R aufweist. Diese einzelnen Einheiten 2 sind so ausgelegt, daß sie mit ausreichend freiem Luftraum an den Seiten der Einheit (oder vorne und hinten an der Einheit) wirksam arbeiten können, um eine Überhitzung zu verhindern. Wenn jedoch diese Einheiten in den Gestellen 1 so eng zueinander montiert sind, daß ihre Frontplatten 13 untereinander bündig abschließen (und somit ein gefälliges Aussehen bieten), kann eine Überhitzung der nachgeschalteten Einheiten eintreten, weil die Luftspalte 11 zwischen angrenzenden Gestellen eng und die Einheiten 2 (mit seitlichen Lufteinlässen und -auslässen) in der gleichen Modulhöhe angeordnet sind. Durch Bauteile in den Einheiten 2 eines vorgeschalteten Gestells erwärmte Luft wird deshalb von ihren Luftauslässen 5 zu den Einlässen 4 der Einheiten 2 im angrenzenden nachgeschalteten Gestell geleitet. Die Lufttemperaturdifferenz in jedem Gestell 1 ist daher kumulativ.

Fig. 1e, auf die nunmehr Bezug genommen wird, zeigt die Temperaturen, die in einer herkömmlichen Installation mit nur drei Gestellen gemessen wurden, von denen jedes eine Säule aus 10 elektronischen Einheiten enthält, die alle über seitliche Lufteinlässe und -auslässe (wie in Fig. 1c dargestellt) verfügen.

Diese Figur zeigt aufeinanderfolgende Anstiege der Lufttemperatur von Gestell zu Gestell, so daß die Temperatur der aus dem letzten Gestell austretenden Luft oben etwa 55°C und unten etwa 34°C beträgt, wodurch es zu einer Überhitzung der Einheiten in den vorgeschalteten Gestellen kommen kann, so daß diese frühzeitig ausfallen. Höhere Lufttemperaturen fallen oben am Gestell an, weil erwärmte Luft dazu neigt, nach oben zu steigen.

Obwohl der rückseitige Luftraum 12, verglichen mit den engen Spalten 11 zwischen angrenzenden Gestellen, recht groß ist, enthält er viele Kabel, und dies trägt nicht dazu bei, daß genügend Kühlluft zwischen die Gestelle gelangen kann, um eine Überhitzung zu verhindern.

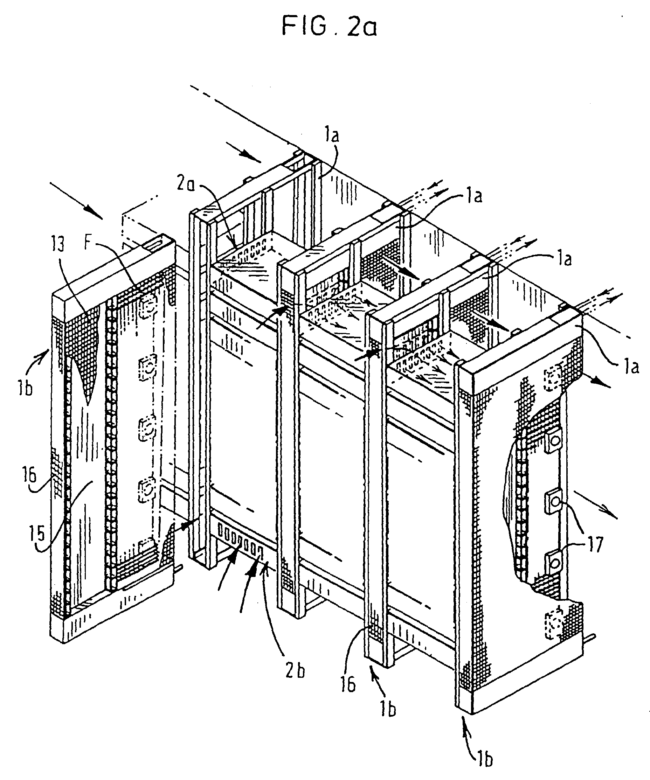

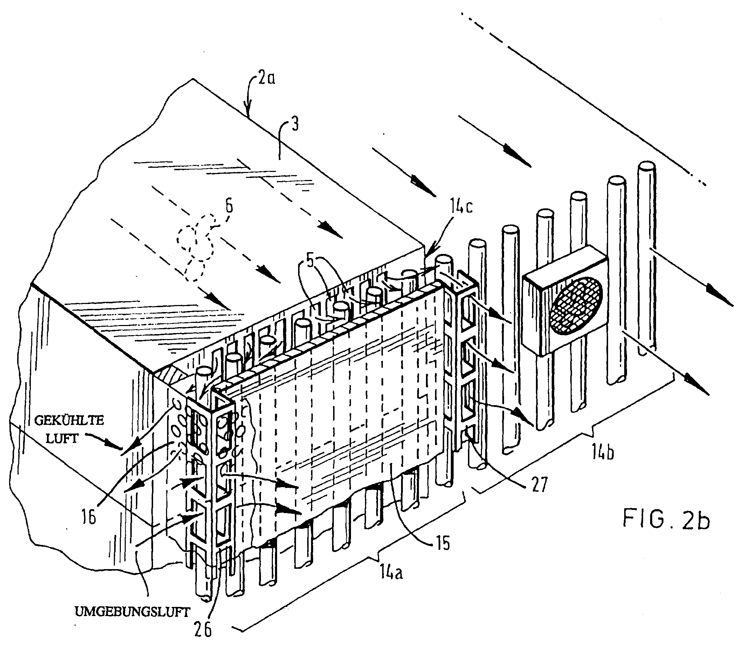

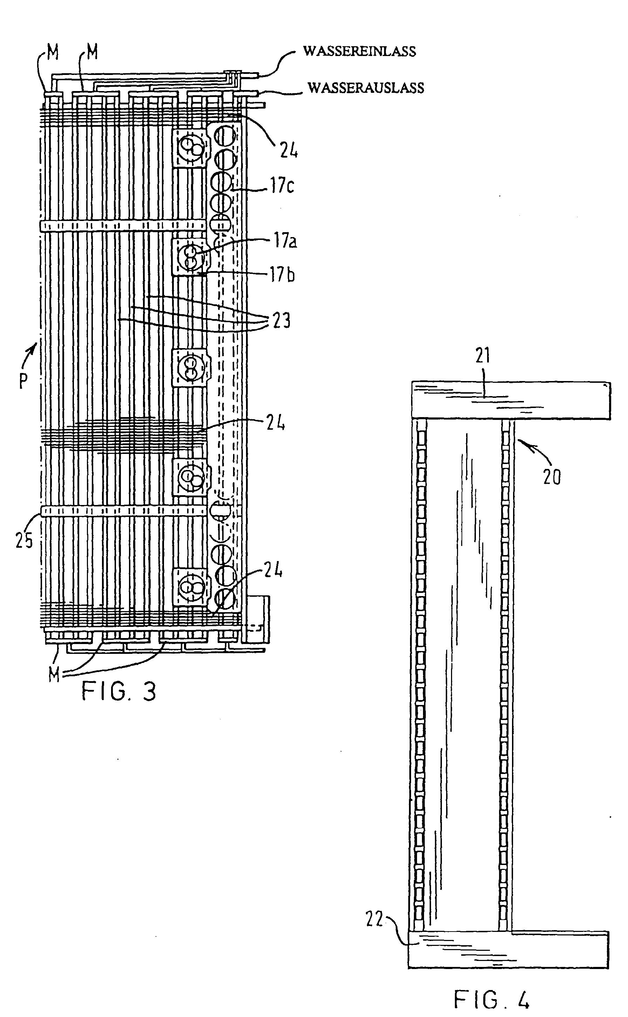

Fig. 2a, auf die nunmehr Bezug genommen wird, zeigt eine Ausführungsform der vorliegenden Erfindung, bei der ähnliche Einheiten 2 übereinander in Gestellen 1 montiert sind, wobei die Einheiten 2 seitliche Lufteinlässe/Luftauslässe besitzen. Die Gestelle umfassen Fixierrahmen 1a für die Aufnahme schlangenabstützender Rahmen 1b, die in gleitender Weise in den von den Fixierrahmen 1a definierten Spalt 11 eingefügt werden können. Die Fixierrahmen 1a verfügen auch über (nicht im Detail dargestellte) Stützen für die Einheiten 2, so daß diese wie Schubladen in einem Schrank aufgenommen werden können. Der entfernbare Rahmen 1b stützt eine mit Rippen ausgestattete Rohranordnung P ab, die der in Fig. 3 gezeigten Rohranordnung ähnelt. Die Rohranordnung P besitzt einen zwischen Gestellen vorgesehenen Abschnitt 14a und einen rückseitigen Luftraumabschnitt 14b, wie in Fig. 2b dargestellt. Der Abschnitt 14a ist in Fig. 2a nicht dargestellt, er belegt jedoch einen seitlichen Luftraum 14c zwischen einem Lochblech 13 und einem Prallblech 15. Fig. 2a zeigt einen Vorschlag für die Anordnung der Rippen F am Abschnitt 14b dieser Rohranordnung. Die Rohranordnung P umfaßt zwei Abschnitte 14a, 14b, um der in den seitlichen Luftraum 14c des Spaltes 11 zwischen angrenzenden Gestellen einströmenden bzw. der hinter den Gestellen durch den rückseitigen Luftraum 12 strömenden Luft Wärme zu entziehen. Eine Einheit 2b mit einem vorderen Lufteinlaß und einem rückseitigen Luftauslaß ist beispielsweise am Boden eines Gestells dargestellt.

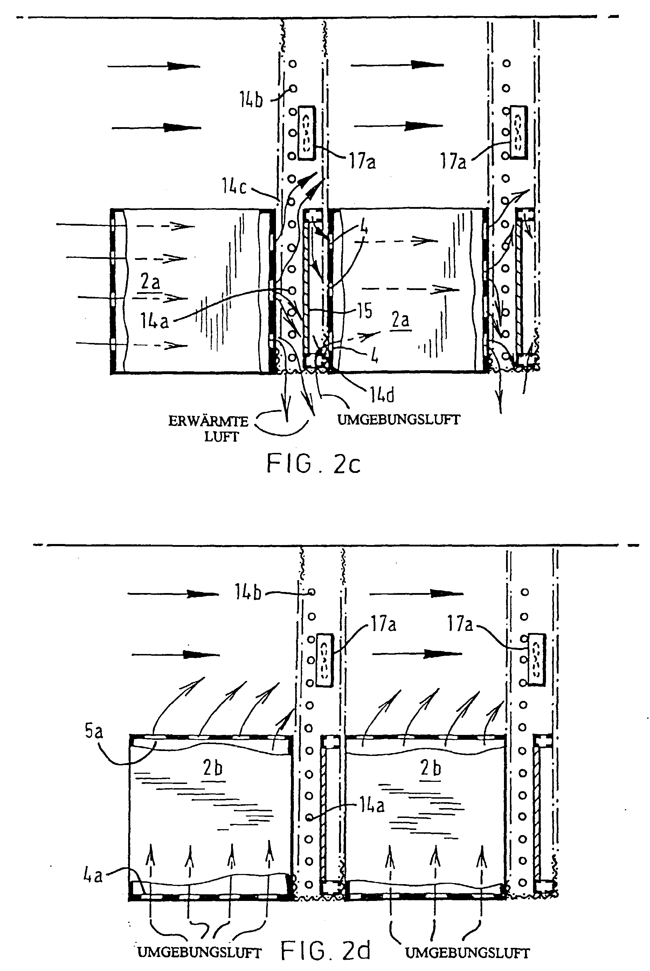

Fig. 2b ist eine perspektivische Schnittansicht und Fig. 2c eine Draufsicht, aus denen die Luftströmung in den Einheiten 2a mit seitlichen Lufteinlässen und -auslässen ersichtlich ist. In den Einlaß der Einheit 2a eintretende Luft nimmt Wärme von den Bauteilen im Gehäuse auf und wird dann durch den Lüfter 6 gezwungen, aus dem Auslaß 5 auszutreten, wo sie in einen seitlichen Luftraum 14c zwischen der Einheit 2a und dem Abschnitt 14a der Rohranordnung eintritt. Die Rohranordnung verläuft durch mehrere horizontal angeordnete (in Fig. 2b nicht dargestellte) Rippen, die aus Gründen der Übersichtlichkeit in einigen der Zeichnungen nicht dargestellt sind. Ein hinter dem Abschnitt 14a der Rohranordnung angeordnetes Prallblech 15 verhindert, daß die erwärmte Luft durch die Spalte zwischen den Rohren strömt und direkt in die Lufteinlässe 4 der nächsten angrenzenden Einheit 2a eintritt. Statt dessen wird die erwärmte Luft durch das Prallblech umgelenkt und dazu veranlaßt, turbulent über die Rohre des Abschnitts 14a zu den Seiten des Prallblechs 15 hin zu strömen. Mittels des durch die Rohranordnung strömenden Kühlmittels wird daher dieser Luft Wärme entzogen, wobei ein Teil der gekühlten Luft durch den Spalt 11a und die Lochabdeckung 16 nach außen in den Aufstellungsraum und ein weiterer Teil durch den Ausgang des seitlichen Luftraums 14c nach außen in den rückseitigen Luftraum 12 gelangt. Da das Prallblech 15 einen Druckabfall im seitlichen Luftraum 14d (der sich zwischen dem Prallblech 15 und den Lufteinlässen 4 der Säule der Einheiten 2a im nächsten Gestell befindet) bewirkt, wird kalte Luft dazu veranlaßt, vom Aufstellungsraum aus über die (vorne vorgesehene) Lochabdeckung 16 in den Luftraum 14d zu strömen, und wird außerdem (durch die Lüfter 6 in den nächsten Einheiten 2a) dazu veranlaßt, in diese Lufteinlässe der Einheiten 2a im nächsten angrenzenden Gestell zu strömen. Gekühlte Luft aus dem rückseitigen Luftraum 12 kann auch in den seitlichen Luftraum 14d (wie in Fig. 2c angezeigt) eintreten und gelangt dann in die Lufteinlässe 4 der nachgeschalteten Einheiten 2a. Dank dieser Anordnung werden die Einheiten in angrenzenden Gestellen in wirksamer Weise mit kühler Luft mit annähernd ähnlichen Temperaturen versorgt. Dies geschieht in jedem der Spalte 11 (d.h. in den seitlichen Lufträumen) zwischen angrenzenden Gestellen entlang der Installation.

Wie aus Fig. 2d ersichtlich, auf die nunmehr Bezug genommen wird, besitzen einige Einheiten 2b Gehäuse mit vorderen und rückseitigen Lufteinlässen und -auslässen 4a, 5a, wodurch Umgebungsluft aus dem Aufstellungsraum durch die vorderen Lufteinlässe 4a gezogen wird, so daß sie dann über die Bauteile im Gehäuse strömt, bevor sie durch den Lüfter 6 aus den rückseitigen Luftauslässen herausgedrückt wird. Diese erwärmte Luft gelangt in den rückseitigen Luftraum, wo sie hinter die Einheiten 2b und durch jeden der aufeinanderfolgenden Abschnitte 14b der Rohranordnungen strömt. Dieser Luftstrom wird durch Lüfter 17a verstärkt, die auf Konsolen 17b am Abschnitt 14b der Rohranordnung abgestützt sind. Somit wird die in den Einheiten 2b erwärmte Luft beim Durchströmen der aufeinanderfolgenden Abschnitte 14b der Rohranordnungen gekühlt, die sich nach hinten in den rückseitigen Luftraum 12 auf der Rückseite der Gestelle erstrecken. Dadurch wird der größte Teil der Wärme entzogen, so daß die das Ende der Installation erreichende Luft nahezu auf Raumtemperatur abgekühlt ist, wenn sie durch den letzten (nicht dargestellten) seitlichen Luftraum am Ende der Installation in den Aufstellungsraum zurückgeführt wird.

Die Rohranordnung umfaßt somit die Abschnitte 14a, 14d, die als Kühlkörper für die Wärme dienen, die "unterwegs" von der Luft aufgenommen wird, die von den Lüftern dazu veranlaßt wird, durch die Einheiten 2a, 2b zu strömen. Der Nettoeffekt besteht darin, daß die erwärmte Luft ausreichend gekühlt wird, so daß jede der Einheiten 2 in wirksamer Weise mit Luft mit ähnlichen Temperaturen versorgt wird, wodurch sich ein ähnlicher Lufttemperaturabfall in jeder Säule der Einheiten 2, jedoch kein kumulativer Effekt wie bei der herkömmlichen Installation ergibt.

In Fig. 4, auf die nunmehr Bezug genommen wird, ist die Rahmenkonstruktion 20 für die Rohranordnung dargestellt, ohne jedoch die Rohranordnung selbst zu zeigen. Die Rahmenkonstruktion besteht aus oberen und unteren Kastenkonstruktionen 21, 22, in denen Verteiler M untergebracht sind, die oben und unten mit der in Fig. 3 dargestellten Rohranordnung verbunden sind.

Wie aus Fig. 3, auf die nunmehr Bezug genommen wird, ersichtlich, umfaßt die Rohranordnung parallel angeordnete Paare Kupferrohre 23, die durch mehrere Rippen 24 verlaufen, die sich über die gesamte Anordnung erstrecken. Diese Rohre leiten Wasser nach unten und anschließend nach oben über Verteiler oder verbindende Rohrabschnitte M. Dadurch wird das Wasser in den Rohren dazu veranlaßt, in einem Serpentinenweg in der Rohranordnung auf- und abwärts durch den seitlichen Raum zwischen den angrenzenden Gestellen und ebenfalls durch den rückseitigen Luftraum zu strömen. Es sind Verteiler dargestellt, die oben und unten mit den parallelen Rohrabschnitten verbunden sind (auf einer Seite der Rohranordnung in Fig. 3 ist jedoch ein einzelnes Paar Rohre dargestellt). Die unteren Verteiler können (nicht dargestellte) Ventile zum Befüllen und Entleeren umfassen, wobei die oberen Verteiler mit (nicht dargestellten) Ventilen zum Entlüften verwendet werden. Die Rohranordnung wird vorzugsweise von unten aus nach oben befüllt, indem die oberen Ventile zum Entlüften geöffnet werden, wenn Wasser an den unteren Verteilern eintritt. Die Rohranordnung kann über die Ventile in den unteren Verteilern entleert werden, wenn es erforderlich ist, die die Rohranordnung abstützende Rahmenkonstruktion für Wartungsarbeiten zu entfernen.

Wie ebenfalls aus Fig. 3 ersichtlich, sind Hilfslüfter 17a auf Konsolen 17b montiert, die von einem an der Rohranordnung befestigten Lochblech 17c abgestützt werden. Das Blech enthält eine Reihe von Öffnungen, die es zulassen, daß Luft durch die Rohranordnung in der Nähe der Konsolen strömt.

Fig. 3 zeigt in schematischer Darstellung die quer über die Rohre der Anordnung verlaufenden Rippen, wobei diese sich von oben nach unten über die Rohranordnung erstrecken. Die Rohre werden von dazwischenliegenden Rahmenelementen 25 abgestützt.

Aus Fig. 2b, auf die nunmehr Bezug genommen wird und die eine Vergrößerung eines Abschnitts der Installation von Fig. 2a zeigt, ist ersichtlich, daß Luft aus dem Auslaß einer vorgeschalteten Einheit austritt und dann auf den Abschnitt 14a der Rohranordnung trifft, wo sie turbulent über die Rohranordnung strömt (und gekühlt wird), bevor sie vorne über die Lochabdeckung 16 und den Ausgang des seitlichen Luftraums 14c austritt. Umgebungsluft tritt über die Lochabdeckung 16 und das Lochblech 26 vorne ein. Das Lochblech 27 ermöglicht es, daß gekühlte Luft in den rückseitigen Luftraum und ebenfalls zurück in den seitlichen Luftraum 14d (siehe Fig. 2c) strömt.

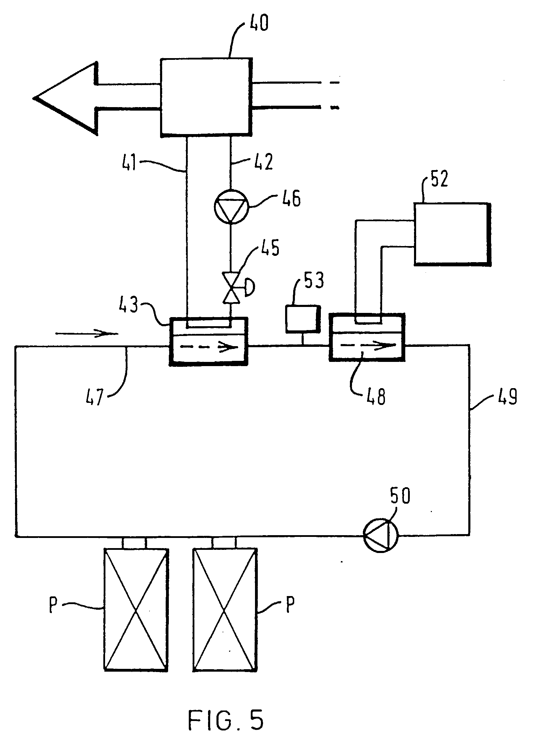

Fig. 5, auf die nunmehr Bezug genommen wird, zeigt ein System, mit dem jede der Rohranordnungen, die zwischen angrenzenden Gestellen montiert sind, mit Kühlmittel (d.h. Wasser) versorgt wird. Ein Hauptkälteerzeugungssystem 40, (das Bestandteil der Anlage im Gebäude sein kann, die mit der Klimaeinrichtung verbunden ist), besitzt Vor- und Rücklaufrohre 41, 42, die mit einem primären Wärmetauscher 43 verbunden sind. Tieftemperaturkühlmittel fließt daher in der primären Schleife vom Hauptsystem 40 aus durch das Rohr 41 zu einer Seite des Wärmetauschers 43, bevor es durch das Rohr 42 zurückgeführt wird. Das Rohr 42 umfaßt ein Regelventil 45 und eine Pumpe 46. Der Wärmetauscher 43 trennt das Kühlmittel im Hauptkälteerzeugungssystem von einer zweiten Schleife ab, die Wasser enthält, das als Kühlmittel in den Rohranordnungen P verwendet wird. Diese sekundäre Schleife umfaßt das Zulaufrohr 47, das mit der wasserführenden Seite eines Wärmetauschers 48 verbunden ist, sowie ein Rücklaufrohr 49, durch das tiefgekühltes Wasser über die Pumpe 50 zu den mit den Rohranordnungen P verbundenen Verteilern zurückgeführt wird. Es ist eine vergleichsweise einfache Aufgabe, den Wärmetauscher 47 mit dem Hauptkälteerzeugungssystem zu verbinden, um eine konstante Versorgung mit Tiefkühlwasser mit einer Vorlauftemperatur von, sagen wir, 14°C aufrechtzuerhalten. Dieses Tiefkühlwasser entzieht der erwärmten Luft, die über die Rohranordnungen P strömt, Wärme, so daß die Rücklauftemperatur auf etwa 17°C ansteigt.

Für die Fachleute auf diesem Gebiet ist klar erkennbar, daß die sekundäre Schleife mit den Wärmetauschern 43, 48, den Rohren 47, 49 sowie den Rohranordnungen P einen gewissen Strömungswiderstand aufweist und daß die Pumpe 50 einen gewissen Strömungsdruck erzeugt, wodurch die Strömungsmenge bestimmt wird. Es kann somit ein Modulsystem ausgelegt werden, bei dem Rohre mit bestimmten Durchmessern, Längen und Konfigurationen (z.B. Bögen) zum Einsatz und erforderliche Temperaturen und Strömungsmengen in der Primär- und Sekundärschleife zur Anwendung kommen.

Um eine Überhitzung der auf Gestellen montierten Einheiten im Falle eines Ausfalls der Stromversorgung des Hauptkälteerzeugungssystems 40 zu verhindern, ist ein Reservegenerator und Hilfskälteerzeugungssystem 52 mit dem Wärmetauscher 53 im Rohr 49 verbunden. Dieser Hilfsgenerator 52 wird in Reaktion auf ein Ausgangssignal des Temperatursensors 53, der die Strömungstemperatur feststellt, automatisch eingeschaltet. Dieser Temperatursensor kann beispielsweise empfindlich genug sein, um zu bewirken, daß der Hilfsgenerator 52 eingeschaltet wird, wenn die Strömungstemperatur um lediglich 1°C auf, sagen wir, über 14°C ansteigt. Wenn also das Hauptkälteerzeugungssystem 40 aufgrund einer Stromunterbrechung oder eines Fehlers ausfallen sollte, oder wenn die Strömungstemperatur aus irgendeinem Grund höher als üblich ansteigen sollte (vielleicht an einem heißen Tag), wird der Hilfsgenerator 52 in Gang gesetzt, um den Tiefkühlwasserstrom auf der korrekten Temperatur zu halten. Da die elektronischen Einheiten 1 ebenfalls von einer ausgefallenen Stromversorgung abgetrennt werden würden, müßten somit die Einheiten, in denen die Wärme über eine gewisse Zeit zurückgehalten werden würde, zusätzlich gekühlt werden, bis die normale Stromversorgung wieder funktioniert.

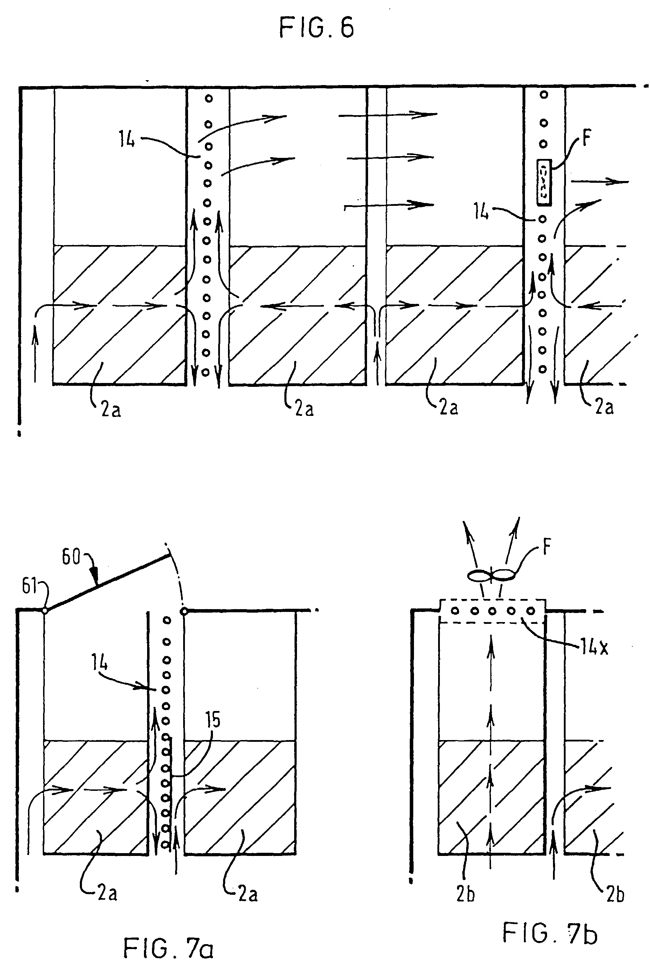

Während sich die bevorzugte Ausführungsform der vorliegenden Erfindung mit dem Problem der Vermeidung kumulativer Temperaturanstiege von Gestell zu Gestell auseinandersetzt, wobei elektronische Einheiten über seitliche Lufteinlässe und -auslässe verfügen (wodurch die Kühlluft in der gleichen Richtung strömt), kann es sein, daß die Richtung des Luftstroms durch eine elektronische Einheit nicht immer gleich ist. Eine Installation kann beispielsweise den Einbau elektronischer Einheiten, die von verschiedenen Unternehmen hergestellt wurden, umfassen, von denen einige seitliche Lufteinlässe/-auslässe mit einem von links nach rechts verlaufenden Luftstrom, andere seitliche Lufteinlässe/-auslässe mit einem von rechts nach links verlaufenden Luftstrom und weitere Einheiten einen von vorne nach hinten verlaufenden Luftstrom aufweisen. Diese müssen auf angrenzenden Gestellen im selben Raum untergebracht werden. Es kann somit eine Situation eintreten, in der eine Säule aus elektronischen Einheiten in einem Gestell Luftauslässe besitzt, die den Luftauslässen einer Säule aus elektronischen Einheiten in einem angrenzenden Gestell zugewandt sind, so daß erwärmte Luft in entgegengesetzten Richtungen in den Zwischenraum zwischen den Gestellen strömt. Dieses Problem kann dadurch gelöst werden, daß im Zwischenraum eine Rohranordnung ohne Verwendung von Prallblechen installiert wird, da die zusammentreffenden Luftströme wesentlich mehr Turbulenz als üblich hervorrufen und somit ein größerer Wärmetausch mit dem durch die Rohranordnung strömenden Kühlmittel bewirkt wird. Dies ist schematisch in Fig. 6 dargestellt, die in einer Draufsicht eine Ebene von auf Gestellen montierten Einheiten 2a zeigt, die in der gleichen Modulhöhe montiert sind, wobei (nicht dargestellte) seitliche Lufteinlässe und -auslässe vorgesehen sind, die einen Luftstrom in entgegengesetzten Richtungen (durch die Pfeile in den Einheiten dargestellt) und aufeinandertreffende Luftströme in der Nähe der Rohranordnung 14 bewirken. Dies kann den Gestellzwischenabschnitt 14a und den rückseitigen Luftraumabschnitt 14b, wie in Fig. 2b gezeigt, umfassen. Fig. 6 zeigt auch den Lüfter F, der im rückseitigen Rohrabschnitt angeordnet ist. Wie aus Fig. 6 ersichtlich, tritt Umgebungsluft in abwechselnde Spalte ein und wird nach erfolgter Kühlung von den Rohranordnungen in die abwechselnden Spalte zurückgeführt. Ein Teil der gekühlten Luft strömt in den rückseitigen Luftraum hinein und wird vom Lüfter F an der Rückseite entlanggeführt.

Fig. 7a ist eine ähnliche Draufsicht, die zwei seitlich zueinander angeordnete elektronische Einheiten darstellt, die über seitliche Lufteinlässe und einen in der gleichen Richtung verlaufenden Luftstrom verfügt sowie die Rohranordnung 14 und das Prallblech 15 umfaßt. In diesem Fall ist eine rückseitige Platte 60 der Gestellanordnung (bei 61) schwenkbar montiert, so daß ein Zugang zum rückseitigen Luftraum und zur Rückseite der Einheiten 2a geschaffen wird. Dies ermöglicht eine weitere Modifizierung, wie aus der Draufsicht von Fig. 7b ersichtlich, wo die entfernbar montierte rückseitige Platte 60 durch eine Rohranordnung 14x und den Lüfter F ersetzt wurde, um dadurch Luft in den hinter dem Gestell befindlichen Raum, d.h. in den Aufstellungsraum, in dem die Ausrüstung installiert ist, hineinzuziehen. In diesem Fall sind die elektronischen Einheiten 2b so ausgeführt, daß Luft durch einen vorderen Lufteinlaß, nach außen durch einen rückseitigen Luftauslaß und in den rückseitigen Luftraum strömt.

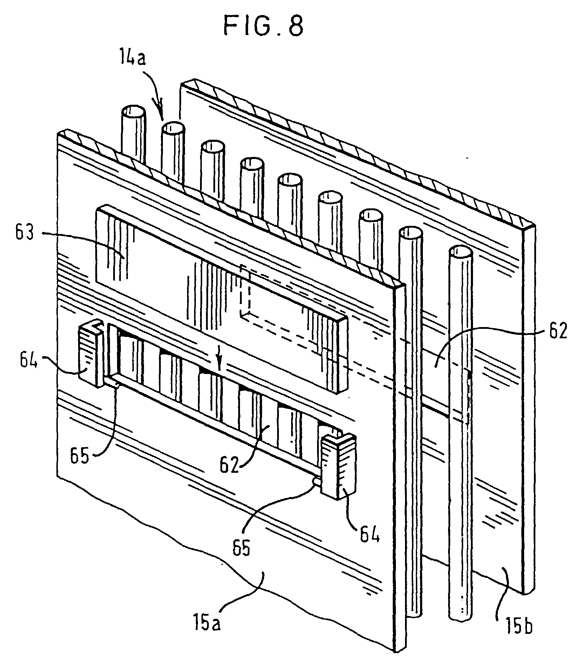

Was das Problem der Auseinandersetzung mit gegenläufigen Luftströmen betrifft, wie in Fig. 6 dargestellt, ist in Fig. 8 eine weitere Modifizierung dargestellt, die angewendet werden kann, um die Konfiguration des Prallblechs 15 zu verändern. Wie aus Fig. 8 ersichtlich, werden zwei Prallbleche 15a, 15b gemeinsam mit einem Rohrzwischenabschnitt 14a verwendet. Jedes Blech 15a, 15b umfaßt einen rechtwinkligen Ausschnitt 62 (auf der Ebene des Luftauslasses 5 der entsprechenden elektronischen Einheit 2a; nicht dargestellt), der von einem Gleitblech 63 abgedeckt sein kann, das sich in Führungen 64, eine auf jeder Seite des Ausschnitts 62, hineinschieben läßt. Das Blech 63 ist oberhalb des Ausschnitts 62 in Fig. 8 (künstlich) dargestellt, weil es entweder an der vorgesehenen Stelle einfach eingelegt wird, so daß es stumpf auf den Anschlägen 65 anliegt und dann die Öffnung 62 verschließt, oder nicht benutzt wird. Im Falle angrenzender Einheiten mit seitlichen Lufteinlässen/-auslässen würde das Abdeckblech 63 auf der Seite des Rohrabschnitts 14a, der erwärmte Luft aus dem Auslaß 5 der Einheit 2a im vorgeschalteten Gestell erhält, entfernt. Bei dem dem Rohrabschnitt 14a nachgeschaltet angeordneten Prallblech würde das Abdeckblech 63 vorgesehen. Die Positionen der Bleche 63 würden sich umkehren, wenn der Luftstrom in entgegengesetzter Richtung verläuft, d.h. bei ähnlichen elektronischen Einheiten mit seitlichen Lufteinlässen/-auslässen, aber mit in entgegengesetzter Richtung verlaufendem Luftstrom. Im Falle angrenzender Einheiten, bei denen der Luftstrom in entgegengesetzten Richtungen (wie in Fig. 6) verläuft, würden jedoch beide Abdeckbleche 63 entfernt. Die in Fig. 8 dargestellte Prallblechanordnung kann daher so ausgeführt sein, daß, abhängig von der Richtung des Luftstroms, unterschiedliche Anordnungen elektronischer Einheiten in den Gestellen untergebracht werden können.

Während das Prallblech 15 verschiedene Lochbleche und Bleche, die sich öffnen lassen, umfassen kann, kann es auch wie eine Jalousie konfiguriert sein, so daß entweder die gesamte Fläche der Jalousie oder Abschnitte davon geöffnet oder geschlossen werden können, um die erforderlichen Luftstromcharakteristika zu erzielen.

## Patentansprüche

1. Kühlsystem für in Gestellen (1) montierte elektronische Einheiten (2), bei dem jede der Einheiten (2) ein Gehäuse (3) mit einem Lufteinlaß (4, 4a), einem Luftauslaß (5, 5a) und einer Vorrichtung umfaßt, mit der ein Umgebungsluftstrom vom Einlaß zum Auslaß herbeigeführt wird, um die Inhalte der elektronischen Einheit (2) zu kühlen;
wobei das Kühlsystem mindestens eine Kälteeinheit zur Anordnung zwischen angrenzenden vorgeschalteten und nachgeschalteten Gestellen (1) umfaßt, wobei die Kälteeinheit Mittel für den Anschluß an eine Wärmeabzugsvorrichtung besitzt, so daß, wenn zur Kälteeinheit Luft gelangt, die beim Durchgang durch eine oder mehrere Einheiten in einem vorgeschalteten Gestell erwärmt wurde, der Luft, bevor sie zur Umgebungsluft zurückgeführt wird, durch die Kälteeinheit Wärme entzogen wird.

2. Kühlsystem nach Anspruch 1, bei dem die Kälteeinheit für eine Anordnung zwischen angrenzenden Gestellen (1), auf denen die elektronischen Einheiten (2) montiert sind, vorgesehen ist, so daß ein in einer Richtung verlaufender Kühlluftstrom zwischen vorgeschalteten und nachgeschalteten Gestellen erfolgt, wodurch gekühlte Luft aus der dazwischen angeordneten Kälteeinheit entweder zur Umgebungsluft zurückgeführt wird oder in die Lufteinlässe einer elektronischen Einheit in einem nachgeschalteten Gestell strömt.

3. Kühlsystem nach Anspruch 1, bei dem die Kälteeinheit für eine Anordnung zwischen gegenüberliegenden Gestellen (1), auf denen elektronische Einheiten (2) montiert sind, vorgesehen ist, so daß entgegengesetzt verlaufende Kühlluftströme zwischen den vorgeschalteten und nachgeschalteten Gestellen (1) erfolgen, wodurch gekühlte Luft sowohl von den vorgeschalteten als auch von den nachgeschalteten Gestellen (1) zur Umgebungsluft zurückgeführt wird.

4. Kühlsystem nach einem der vorstehenden Ansprüche, bei dem die Kälteeinheit eine Rohranordnung mit mindestens einem Abschnitt zur Installation in einem Spalt zwischen den angrenzenden Gestellen (1) umfaßt.

5. System nach Anspruch 4, bei dem die Rohranordnung ein Rohr oder Rohre umfaßt, die Kühlmittel über einen kontinuierlichen Serpentinenweg leiten.

6. System nach einem der vorstehenden Ansprüche, weiterhin umfassend ein Prallblech (15) zur Umlenkung des erwärmten Luftstroms, der aus den Luftauslässen (5, 5a) der Einheiten (2) im vorgeschalteten Gestell (1) austritt, um den Wärmeübergang zur Kälteeinheit zu erhöhen.

7. System nach Anspruch 6, bei dem das Prallblech (15) die Kälteeinheit so abdeckt, daß erwärmte Luft, die aus den Luftauslässen (5) der vorgeschalteten Einheiten (2) austritt, zu einer oder beiden Seiten der Kälteeinheit umgelenkt wird, so daß sie über die Kälteeinheit strömt und gekühlt wird, bevor sie von den Gestellen (1) weggeleitet wird.

8. System nach Anspruch 6 oder 7, bei dem es sich bei dem Prallblech (15) um ein nach der Kälteeinheit (bezogen auf die Richtung des erwärmten Luftstroms) vorgesehenes Blech handelt, und wobei das Prallblech (15) von einem oder mehreren Lochelementen flankiert ist, die es zulassen, daß gekühlte Luft von den Gestellen (1) weg in die Umgebungsluft entweicht.

9. System nach einem der Ansprüche 6 - 8, bei dem die elektronischen Einheiten (2) so montiert sind, daß ein in gleicher Richtung verlaufender Luftstrom in angrenzenden Gestellen (1) erfolgt und das Prallblech (15) so dimensioniert und positioniert ist, daß eine Druckdifferenz zwischen einem vorgeschalteten Raum, der den erwärmten Luftstrom aufnimmt, und einem nachgeschalteten Raum zwischen dem Prallblech (15) und den Lufteinlässen (4, 4a) der Einheiten (2) im nächsten angrenzenden Gestell (1) bewirkt wird, so daß der Luftdruck im nachgeschalteten Raum geringer als derjenige im vorgeschalteten Raum ist, wodurch die gekühlte Luft, die aus der Kälteeinheit austritt, von den Gestellen (1) weggeleitet wird, nachdem sie über die Kälteeinheit geströmt ist, und Umgebungsluft in den nachgeschalteten Luftraum hineingezogen wird.

10. System nach einem der Ansprüche 1 - 5, weiterhin umfassend eine Prallblechanordnung mit Öffnungen, die sich schließen lassen, um den Luftstrom aus dem Luftauslaß (5, 5a) der elektronischen Einheit (3) im vorgeschalteten Gestell (1) einzuregulieren.

11. System nach einem der vorstehenden Ansprüche, umfassend eine Rahmenkonstruktion (20) zur Abstützung der Kälteeinheit, wobei die Rahmenkonstruktion (20) so dimensioniert ist, daß sie zwischen angrenzenden Gestellen (1) eingefügt werden kann.

12. System nach Anspruch 2, umfassend Mittel zur Erzielung eines reduzierten Luftdrucks in einem der Kälteeinheit nachgeschaltet vorgesehenen Spalt, um Umgebungsluft und/oder gekühlte Luft dazu zu veranlassen, vom Spalt aus in die Lufteinlässe (4, 4a) der nachgeschalteten elektronischen Einheiten (2) zu strömen.

13. System nach einem der vorstehenden Ansprüche, bei dem das Kühlsystem weiterhin eine Hilfskälteeinheit umfaßt, die auf der Rückseite der Gestelle (1) so verläuft, daß sie mit rückseitigen Lufträumen hinter den Gestellen (1) kommuniziert und dadurch in den rückseitigen Lufträumen strömende erwärmte Luft gekühlt wird, wobei die Hilfskälteeinheit entweder eine Erweiterung der zwischengeschalteten Kälteeinheit darstellt oder separat davon betrieben wird.

14. System nach Anspruch 13, bei dem die Hilfskälteeinheit eine Hilfsrohranordnung umfaßt.

15. System nach Anspruch 14, weiterhin umfassend Mittel, mit denen ein Luftstrom durch die Hilfskälteeinheit herbeigeführt wird.

16. System nach einem der vorstehenden Ansprüche, bei dem die Kälteeinheit auf einer Rahmenkonstruktion (20) montiert ist, die sich aus dem Raum zwischen angrenzenden Gestellen (1) entfernen läßt, wobei die Rahmenkonstruktion (20) weiterhin reibungsreduzierende Mittel umfaßt, um die Rahmenkonstruktion (20) zwischen angrenzenden Gestellen (1) in gleitender Weise hineinschieben zu können.

17. System nach einem der vorstehenden Ansprüche, umfassend eine Hauptrohranordnung und eine Hilfsrohranordnung, die auf einer Rahmenkonstruktion (20) montiert ist, die sich aus dem Raum zwischen angrenzenden Gestellen (1) entfernen läßt, um Wärme aus Lufträumen zwischen angrenzenden Gestellen (1) bzw. rückseitigen Lufträumen auf der Rückseite der Gestelle (1) abziehen zu können.

18. System nach Anspruch 17, bei dem die Rohranordnungen (mit etwaigen Hilfsrohranordnungen) jeweils ein oder mehrere Rohre umfassen, die in einer parallelen Rohranordnung zwischen einem Kühlmitteleinlaß und einem Kühlmittelauslaß angeordnet sind.

19. System nach Anspruch 18, bei dem die Rohranordnungen parallele Rohrabschnitte umfassen, die vertikal nach unten und dann nach oben verlaufen und oben und unten in der Anordnung durch rohrförmige Elemente verbunden sind.

20. System nach einem der Ansprüche 17 - 19, bei dem die Rohranordnungen Ventile oben und unten in der Anordnung umfassen, wobei die unteren Ventile für das Befüllen der Rohranordnungen mit Kühlmittel benutzt werden, während das obere Ventil als ein Entlüftungsventil dient, wobei das untere Ventil auch dazu benutzt wird, die Rohranordnungen bei Bedarf zu entleeren.

21. System nach einem der vorstehenden Ansprüche, bei dem es sich bei jeder Kälteeinheit (und, falls vorgesehen, auch bei der Hilfskälteeinheit) um ein Modul in einem Modulsystem für Kühleinheiten in Modulgröße in den Gestellen handelt, so daß ein oder mehrere Kälteeinheitmodule vorgesehen werden können, um vorbestimmte Vor- und Rücklauftemperaturen des Kühlmittels, die der Anzahl elektronischer Einheiten (2), die in angrenzenden Gestellen (1) installiert sind, sowie der Anzahl der Gestelle (1) entsprechen, zu erzeugen.

22. Installation, umfassend die elektronische Ausrüstung und das Kühlsystem nach einem der vorstehenden Ansprüche sowie weiterhin umfassend eine Wärmeabzugsvorrichtung, mit der die Kälteeinheiten verbunden sind, um die Versorgung mit dem Kühlmittel zu ermöglichen.

23. Installation nach Anspruch 22, bei der es sich bei dem Kühlmittel um Tiefkühlwasser handelt.

24. Installation nach Anspruch 23, die eine Hilfswärmeabzugsvorrichtung umfaßt, wobei die Hilfsvorrichtung durch einen unabhängigen Stromgenerator betrieben wird, und weiterhin umfassend einen Temperatursensor, der so angeordnet ist, daß er auf die Kühlmitteltemperatur in der Kälteeinheit reagiert, sowie einen Schalter, der auf ein Ausgangssignal des Sensors reagiert, um den Generator in Gang zu setzen, so daß dem Kühlmittel Wärme entzogen wird, wenn die Kühlmitteltemperatur aufgrund eines Ausfalls der Hauptwärmeabzugsvorrichtung einen vorbestimmten Wert überschreitet.

25. Installation nach den Ansprüchen 21 - 24, bei der das Gehäuse jeder elektronischen Einheit eine Frontplatte besitzt, hinter der sich die Einheit in das Gestell hineinerstreckt, und bei der die Lufteinlässe und Luftauslässe an gegenüberliegenden Seiten der elektronischen Einheit angeordnet sind, so daß Luft quer über die Einheit, um deren Inhalte zu kühlen, und anschließend zur Kälteeinheit hin strömt.

26. Installation nach Anspruch 25, bei der die Kälteeinheit von einer Konstruktion abgestützt ist, die einen Luftraum auf der nachgeschalteten Luftseite definiert, die mit Lufteinlässen der Einheiten im nächsten Gestell kommuniziert.

27. Installation nach einem der Ansprüche 22 - 26, bei der das Gehäuse jeder elektronischen Einheit vordere und hintere Platten besitzt, die im dazugehörigen Gestellraum vorne und hinten positioniert sind, wobei die Lufteinlässe und Luftauslässe der letztgenannten elektronischen Einheiten in den vorderen und hinteren Platten vorgesehen sind, so daß Luft von der Vorderseite zur Rückseite der elektronischen Einheit strömt, um deren Inhalte zu kühlen, wobei die elektronischen Einheiten so im Gestell montiert sind, daß auf der Rückseite der Einheit im Gestell ein rückseitiger Luftraum zur Verfügung steht, wobei der rückseitige Luftraum mit den Hilfskälteeinheiten kommuniziert.

28. Installation nach einem der Ansprüche 22 - 27, bei der die Rückseite von einem oder mehreren Gestellen durch eine entfernbare Platte verschlossen ist, um entweder einen Zugang zur Rückseite der elektronischen Einheiten zu ermöglichen oder eine rückseitige Kälteeinheit zu definieren.
